# EUROPEAN PATENT APPLICATION

(11) **EP 0 767 601 A1**
(43) Date of publication of application: **09.04.1997**
(21) Application number: 96307195.6
(22) Date of filing: 01.10.1996
(51) Int. Cl.: H05K 7/20

(54) **Mechanical arrangement of fluid cooled electronic circuit**

(30) Priority: 02.10.1995 US 538066
(71) Applicant: GENERAL ELECTRIC COMPANY, Schenectady, NY 12345 (US)
(72) Inventor: Restanio, Joseph Lee, McKean, Pennsylvania 16426 (US); Bailey, Ronald Barry, Erie, Pennsylvania 16511 (US)
(74) Representative: Goode, Ian Roy

(57) **Abstract**

A cooling system for an electronic switch module mounted to a liquid cooled heat sink assembly includes a manifold (14) for distributing cooling to a plurality of switch modules (10). A coupling system connects the heat sink assembly to the manifold with a liquid inlet and liquid outlet aligned with respective supply and return passageways in the manifold. A liquid storage tank (24) is positioned at a level below the heat sink assembly and a pump (26) pumps liquid from the tank into the supply passageway in the manifold, through the heat sink assembly (12) and into the return passageway. A heat exchanger (30) receives liquid from the return passageway and returns cooled liquid (32) to the storage tank (24). The coupling system includes at least one groove in one of the heat sink assembly and the manifold circumscribing each of the apertures with an elastomeric o-ring positioned in each groove.

## Description

The present invention is directed to power electronic systems and, more particularly, to a mechanical arrangement for liquid cooling of such electronic assemblies which permits replacement of such power electronic assemblies with minimal release of cooling liquid.

Solid state power electronic devices are becoming commonplace in control systems for various high power electronic and electrical applications. For example, it is common practice to utilize power electronic switching devices in inverters and/or converters for providing controlled electrical power to alternating current and/or direct current electric motors. The electronic switches utilized in such systems may be four layer devices in the thyristor family or three layer devices from the transistor family. A common switch used in inverter technology for pulse width modulation is the gate turnoff (GTO) thyristor. More recently, some power circuits have been designed to use insulated gate bipolar transistors (IGBT) in order to reduce circuit complexity since IGBT's do not require the auxiliary turn-off circuits common to thyristor circuits. In the application of these electronic power switching IGBT devices to control systems, it is generally critical to provide a means for removing heat from the devices so as to prevent thermal breakdown under high power load conditions. In some relatively low power applications, it is possible to use air cooled heat sinks in heat exchange relationship with the electronic devices in order to remove sufficient heat to prevent thermal breakdown of the devices. In the higher power applications, air cooling may be insufficient to remove the amount of heat to prevent thermal breakdown of the device and in such occasions, it is common to apply a liquid cooled heat sink to the device so that additional heat can be removed to control the internal junction temperature in the device.

As the use of power electronic devices has transitioned from more exotic applications into ordinary applications such as in the power systems of diesel electric locomotives, it has become necessary to construct systems which can be repaired and/or replaced in field locations which may not have all of the equipment common to a laboratory and may not be manned by highly skilled electronic technicians. Accordingly, it is desirable to reduce the complexity of repair and maintenance of such system so that failed components can be easily replaced with a minimum amount of tools and fixtures using low skill level maintenance personnel. Furthermore, it is desirable that any repair or replacement of electronic systems should be with minimal loss of cooling liquids and with a short replacement time. Accordingly, it is desirable to provide a liquid cooling system for power electronic systems which incorporates easy assembly and disassembly with minimal liquid loss from any incorporated liquid cooled assemblies.

It is a general object of the present invention to provide an improved liquid cooling arrangement for power electronic devices which admits of easy assembly and disassembly.

It is another object of the present invention to provide an improved liquid cooling system for power electronic assemblies which allows replacement of the electronic assemblies with minimal loss of the liquid coolant.

It is still another object of the present invention to provide an improved liquid cooling arrangement for power electronic assemblies which can be assembled and disassembled with a minimum amount of tools and fixtures.

It is still another object of the present invention to avoid the use of special valves, for example, check valves to prevent loss of fluid during assembly replacement.

In accordance with the present invention, there is provided a liquid cooling system for an electrical power system incorporating an electronic switch module in which the switch module may include a plurality of electronic components. The switch module is mounted in heat transfer relationship to a liquid cooled heat sink. The heat sink has a liquid inlet and a liquid outlet for passing liquid through the heat sink. The heat sink is mounted to a manifold in which liquid is circulated. The manifold typically has one passageway for liquid supply and a second passageway as a return line for liquid exiting the heat sink. The heat sink is coupled to the manifold such that the inlet and outlet of the heat sink mate with corresponding apertures in the manifold which allow the liquid to be pumped through the heat sink. A liquid supply tank is positioned at a level below the heat sink and a heat exchanger is coupled in fluid communication with the heat sink and liquid supply tank. A pump is connected in the supply line between the tank and the manifold for pumping the liquid out of the tank up through the manifold and through the heat sink. The liquid exiting the heat sink passes back through the manifold and then into the heat exchanger where it is cooled before being returned to the liquid supply tank. The level of liquid in the supply tank is preferably kept at a value which will allow all the liquid in the system to be drained into the supply tank without retaining any liquid in the heat exchanger, in the manifold, in the switch modules or in the heat sink. Accordingly, when the liquid pump is turned off or inoperative, all of the liquid in the system will drain from the manifold and heat sink and the heat exchanger back into the liquid supply tank. Thus, when the system is shut down for maintenance, all of the liquid will drain out of the heat sink allowing the heat sink and its associated modules to be removed from the manifold with minimal spilling of the liquid from the system. In a preferred form, the heat sinks are attached to the manifold by screws extending through the heat sink and into threaded apertures in the manifold. The interface between the heat sink and manifold incorporates a pair of radially spaced grooves circumscribing each of the apertures on the manifold with O-rings being placed in the grooves. When the fasteners are tightened to pull the heat sink into abutting relationship with the manifold, the elastomeric O-rings are compressed providing a liquid seal between the manifold and heat sink. Accordingly, in the assembled condition, liquid can be pumped through the system without liquid escaping between the manifold and heat sink. The use of the O-rings in the system becomes feasible since liquid leakage during disassembly is not of concern to the mechanic. In prior systems, it was either necessary to provide a connection that automatically sealed when the electronic assembly heat sink was removed or to provide some means of manually draining the liquid from the system during repair and maintenance. Systems requiring automatic sealing become much more expensive and systems requiring manual draining of the system require special containers for the liquid and special procedures for refilling the system since the system is a closed system and must contain uncontaminated liquid. Any contamination or particles in the liquid can block the passages and prevent effective cooling and result in failure of the electronic components.

For a better understanding of the present invention, reference may be had to the following detailed description taken in conjunction with the accompanying drawings in which:
FIG. 1 is a simplified mechanical drawing of a liquid cooling system for electronic modules in accordance with the present invention;
FIG. 2 is a perspective view of one of the electronic modules of FIG. 1 attached to a section of liquid manifold;
FIG. 3 is a plan view of the electronic module assembly of FIG. 2; and
FIG. 4 is a partial plan view of the assembly of FIG. 3 taken along the lines 4-4.

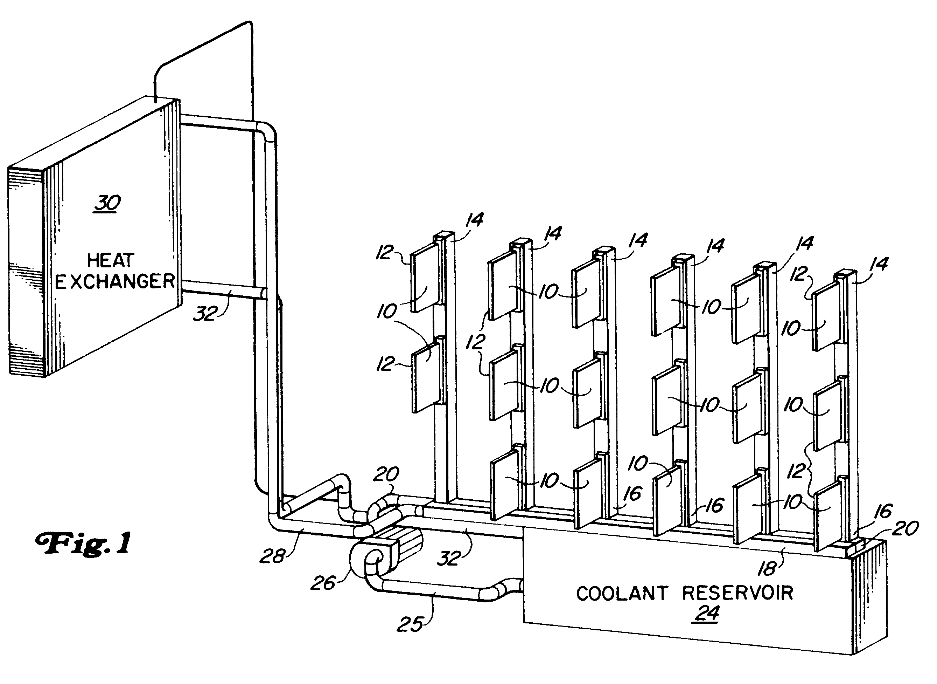

Turning now to FIG. 1, there is shown a simplified mechanical layout of a cooling system for power electronic modules in accordance with the present invention. The system includes a plurality of electronic switch modules 10 each of which is connected to a liquid cooled heat sink assembly 12. For purposes of the present invention, it will be understood that use of the term "heat sink assembly" is intended to encompass any system which couples a liquid in heat transfer relation to the electronic module, including incorporation of tubing or passages in the electronic module itself. The electronic modules 10 and heat sink assemblies 12 are mounted in groups of three on vertically oriented liquid distribution manifolds 14. The manifolds 14 may be mounted in any of various methods well known in the art but typically would be attached to a sidewall of an enclosure in which the electronic modules are maintained in order to minimize exposure of the modules to dust and other contamination. At their lower ends 16, the manifolds 14 are connected in liquid communication with a pair of liquid distribution lines 18 and 20. The distribution line 20 is a supply line for supplying liquid to each of the manifolds 14 while the distribution line 18 is a return line for exhausting or returning liquid from the manifolds 14 after the liquid has been heated by passage through the heat sinks 12 associated with each of the electronic modules 10. As will become apparent in the description to follow, each of the manifolds 14 include a pair of vertically oriented passages for communicating liquid from the supply line 20 to each of the heat sink assemblies 12. The second passage provides a return path for liquid after passing through the heat sink assemblies to be returned to the return line 18. A storage tank or coolant reservoir 24 stores an amount of liquid necessary to provide liquid cooling to each of the heat sink assemblies 12 when the system is operating. Liquid is directed from the storage tank 24 through the supply line 25 to a pump 26. The pump 26 pumps the liquid from the storage tank 24 into the supply line 20 connected to each of the manifolds 14. After the liquid has passed through each of the heat sink assemblies and returned to the return line 18, the liquid is directed via piping 28 to a top inlet port on a heat exchanger 30. The liquid passes through the heat exchanger which removes some of the heat from the liquid and allows the cooled liquid to exit the heat exchanger through outlet piping 32. The outlet piping 32 returns the liquid to the storage tank 24 where it can then be pumped by pump 26 into the supply line 20. The pump 26 is a common motor driven pump for liquids such as water and the heat exchanger 30 is a conventional heat exchanger such as a radiator of the type used in a vehicle. Typically, a fan (not shown) will be operatively associated with the radiator/heat exchanger 30 for blowing air through the radiator to cool the liquid passing through coils of the radiator. The liquid used in the liquid cooling system is typically water mixed with a small amount of an anti-freeze compound.

As will be noted in the mechanical layout of FIG. 1, the storage reservoir or tank 24 is positioned below the level of each of the heat sink assemblies 12. Furthermore, the heat exchanger or radiator 30 is positioned at a level that is above the level of the reservoir 24. More particularly, the reservoir 24 is located at the lowest point in the cooling system. As a result, if the pump 26 is turned off, all of the liquid in the heat exchanger 30 and each of the heat sink assemblies 12 along with the manifolds 14 will drain downward into the reservoir 24. Consequently, all of the components of the system including the heat exchanger 30, the motor and water pump 26, the electronic modules 10 and the water distribution manifolds 14 can be repaired or replaced without concern for water leakage from any of these modules since the water flows to the lowest point and is stored in the reservoir 24 when the system is inoperative. This system thus avoids the concern about fluid spillage or leakage when repairing or replacing the modules.

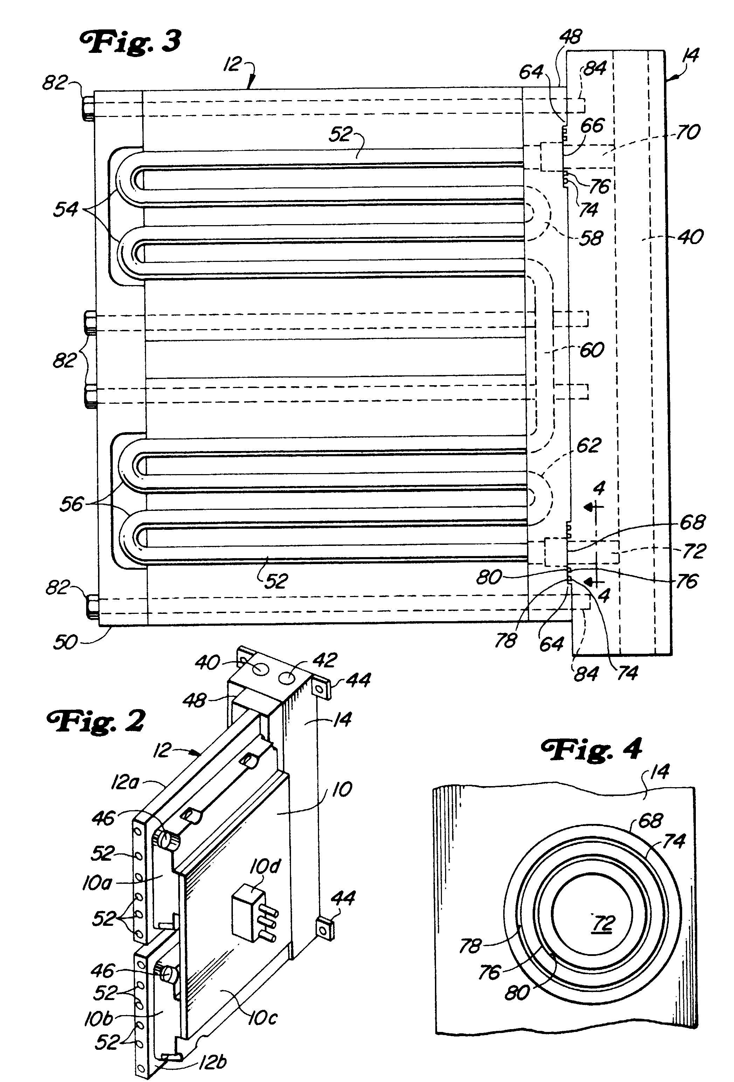

Referring now to FIGS. 2 and 3 in combination, there is shown in FIG. 2 a perspective view of one of the electronic modules 10 and its associated heat sink assembly 12 in conjunction with a portion of a liquid distribution manifold 14. FIG. 3 is a side view of the assembly of FIG. 2 but with the electronic module removed from the heat sink assembly. It will also be noted in FIG. 2 that an end cap has been removed from the nearest end of the heat sink assembly in order to show mounting of the electronic modules and passages in the heat sink assembly. Referring specifically to FIG. 2, the manifold section 14 shows a pair of vertically oriented passages 40 and 42 which are the supply and return lines respectively for liquid flowing through the manifold 14. The manifold 14 is also provided with integral tabs 44 extending outward from the manifold and having apertures passing therethrough for receiving screws or other fasteners to allow the manifold to be attached to a sidewall of an enclosure (not shown) in which the electronic modules are intended to be mounted. Of course, if the electronic modules include integral passages for fluid, the modules 10 may be bolted or attached to manifold 14 directly and the separate heat sink assembly 12 eliminated.

The electronic modules 10 actually comprise a pair of spaced electronic units 10a and 10b each of which include semiconductor devices such as gate turnoff devices. The units 10a and 10b are interconnected by a laminated connector plate 10c on which is attached an external electrical connector 10d. The particular design of the electronic module 10 is immaterial to the present invention and is simply one form of commercially available electronic module. Other types of electronic modules could be mounted to the heat sink assembly 12 in a manner well known in the art. In this particular instance, each of the underlying modules 10a and 10b are attached to corresponding metallic elements 12a and 12b of heat sink assembly 12 by means of screws indicated at 46.

In the illustrative embodiment, the heat sink assembly 12 includes the metallic elements 12a and 12b and a pair of end plates, only one of which is shown at 48 in FIG. 2, which couple the metallic elements 12a and 12b and also provides a circulation path for liquid flowing through the metallic elements. Considering FIG. 3 in conjunction with FIG. 2, it can be seen that the end cap 48 abutting manifold 14 has a counterpart end cap 50 on an opposite end of the metallic elements 12a and 12b. Each of the end caps 48 and 50 contain liquid flow paths which serve to interconnect the horizontal pathways extending through the metallic elements 12a and 12b. More specifically, it can be seen by referring to FIG. 2 and FIG. 3 that each of the metallic elements 12a and 12b include four parallel fluid or liquid flow paths 52 extending through each of the elements. The end cap 50 includes two U-shaped liquid flow paths 54 in the top portion of the cap and two additional U-shaped liquid flow paths 56 in the bottom portion of the end cap. The U-shaped paths 54 and 56 serve to connect the fluid paths 52 at end cap 50. Within end cap 48, three U-shaped paths 58, 60 and 62 serve to connect the opposite ends of the liquid flow paths 52 so that the liquid flow paths 52 are sequentially connected to form a continuous path through the upper and lower metallic elements 12a and 12b of heat sink assembly 12. The right hand end of the top most path 52 and bottom most path 52 are open and connect to apertures passing through the end cap 48. At the outside surface of the end cap 48 opposite the metallic elements 12a and 12b, the apertures passing through the end caps 48 are circumscribed by recessed areas 64. The manifold 14 is provided with a raised land area 66 and 68 which are spaced at a distance sufficient to match the spacing between the recessed areas 66 so that the land areas fit precisely into the recessed areas when the heat sink assembly is positioned on the manifold 14. A horizontally extending aperture 70 extends from the supply passageway 40 through the center of land area 66 thus providing a passage for liquid to flow from passageway 40 into the top most liquid path 52 in upper heat sink element 12a. Similarly, a horizontally extended aperture 72 connects from passage 42 in manifold 14 through the center of land 68 thus providing a connection to the bottom most liquid path 52 in lower heat sink element 12b.

Each of the lands 66 and 68 are formed with grooves 74 and 76 which are concentric with and circumscribe the apertures 70 and 72 respectively. Each of the grooves 74 and 76 is designed to receive a corresponding elastomeric O-ring 78 and 80.

FIG. 4 is an end view of the lower land 68 showing the position and arrangement of the grooves and O-ring seals.

In order to prevent leakage of liquid from the heat sink assembly when it is attached to the manifold 14, the heat sink assembly 12 must be drawn into abutting and mating relationship with the manifold 14. Preferably, such attachment is achieved by using mounting bolts 82 which pass through apertures in each of the end caps 48, 50 and the associated heat sink elements 12a and 12b. The mounting bolts 82 thread into threaded apertures 84 in the manifold 14. By drawing the bolts down in a conventional manner, the heat sink assembly 12 is compressed against the manifold 14 compressing the O-rings 78 and 80 and thereby providing a liquid seal to prevent leakage of liquid at the interface between the manifold and heat sink assembly.

In normal operation, the end caps 48 and 50 are permanently installed with the metallic elements 12a and 12b by the manufacturer of the heat sink assembly. In the event of a failure of the electronic module 10, the entire module and its associated heat sink assembly can be removed for repair at a designated repair facility by simply removing the four mounting bolts 84. Since removal of the module is done when the system is in a non-operating condition, the pump 26 will be turned off and all of the cooling liquid within the system will have drained into the reservoir 24. Consequently, when the mounting bolts 82 are removed and the heat sink assembly and electronic module disengage from the manifold 14, there will be no liquid in the heat sink assembly or manifold 14 and thus no spillage or leakage will occur when the two components are separated. The module can be replaced by simply installing a new module or previously repaired module with its associated heat sink onto the manifold 14 by inserting the four mounting bolts 82 and tightening the mounting bolts to a predetermined torque. The height of the lands 66 and 68 and the depth of the recess 64 are such that when the mounting bolts 82 are drawn to their proper torque, the elastomeric O-ring will be compressed to provide a seal to prevent any leakage at the interface between the heat sink assembly and the manifold 14. Accordingly, it can be seen that the removal and installation of the electronic switch module is optimized for easy access and simple removal. By merely disconnecting the electrical connection to the electronic module and then removing the four mounting bolts, the electronic module can be removed from the system and easily replaced. The system does not require any unusual skills in order to assure proper connection of the electronic module to the manifold. The utilization of the mounting bolts to simultaneously apply both the mechanical attachment and the fluid connection for the heat sink assembly simplifies the system and avoids the need for complicated repair. Minimal skills are therefore needed to replace the electronic module assemblies. Furthermore, the use of the raised land area and the recess in the heat sink assemblies allows for easy alignment of the heat sink assembly to the manifold 14 and minimizes any need to maintain critical dimensions associated with conventional pipe fittings for liquid cooling systems.

## Claims

1. A liquid cooling system for an electrical power system comprising:
an electronic switch module including a plurality of electronic components mounted within said module;
a liquid cooled heat sink assembly coupled in heat transfer relationship to said switch module, said heat sink assembly having a liquid inlet and a liquid outlet;
a manifold including at least a liquid supply passageway and a liquid return passageway extending therethrough, said manifold having generally transversely extending apertures connecting each of said passageways to a surface of said manifold;
a coupling system for connecting said heat sink assembly to said manifold with said liquid inlet and said liquid outlet aligned with a respective one of said apertures from a corresponding one of said supply and return passageways;
a liquid storage tank positioned at a level at least below said heat sink assembly;
a liquid pump coupled in liquid communication between said tank and said manifold for pumping liquid from said tank into said supply passageway in said manifold, through said heat sink assembly coupled thereto and into said return passageway;
a heat exchanger connected for receiving liquid from said return passageway and for returning received liquid to said storage tank; and
wherein liquid volume in said storage tank is sufficiently low to permit liquid to drain from said heat sink assembly into said tank when said pump is inoperative.

2. The system of claim 1 wherein said liquid cooling system is a closed system and including a vent line coupling a top of said heat exchanger to said storage tank.

3. The system of claim 1 wherein said coupling system includes at least one groove in one of said heat sink assembly and said manifold, said groove circumscribing each of said apertures, an elastomeric O-ring positioned in each of said grooves and connecting apparatus for compressing said O-rings in sealing relationship between said manifold and said heat sink assembly.

4. The system of claim 3 wherein said heat sink assembly comprises a pair of vertically spaced metallic elements coupled together at corresponding ends thereof by insulative end connectors, said end connectors including internal passages for liquid flow in a circuitous path through each of said elements in sequence.

5. The system of claim 3 and including a raised land area circumscribing each of said apertures, said groove being formed in said land area.

6. The system of claim 2 wherein said heat exchanger is positioned at a level above said heat sink assembly.

7. The system of claim 1 including a plurality of heat sink assemblies coupled in liquid communication with said manifold, a plurality of manifolds connected in liquid supply arrangement with said storage tank, and a plurality of heat sinks coupled to each of said manifolds.

8. The system of claim 1 wherein said manifold extends in a generally vertical orientation and said heat sink extends in a generally horizontal orientation from said manifold.

9. The system of claim 1 wherein said coupling system includes a plurality of mounting bolts extending through said heat sink assembly and into threaded apertures in said manifold.

10. A liquid cooling system for an electrical power system comprising:
an electronic switch module including a plurality of electronic components mounted to said module;
a liquid cooled heat sink assembly coupled in heat transfer relationship to said switch module, said heat sink assembly having a liquid inlet and a liquid outlet;
a manifold including at least a liquid supply passageway and a liquid return passageway extending therethrough, said manifold having generally transversely extending apertures connecting each of said passageways to a surface of said manifold;
a coupling system for connecting said heat sink assembly to said manifold with said liquid inlet and said liquid outlet aligned with a respective one of said apertures from a corresponding one of said supply and return passageways; and
said coupling system including at least one groove in one of said heat sink assembly and said manifold, said groove circumscribing each of said apertures, an elastomeric O-ring positioned in each said groove and connecting apparatus for compressing each said O-ring in sealing relationship between said manifold and said heat sink assembly.
